# EUROPEAN PATENT APPLICATION

(11) **EP 4 592 885 A1**
(43) Date of publication of application: **30.07.2025**
(21) Application number: 24305150.5
(22) Date of filing: 29.01.2024
(51) Int. Cl.: G06F 30/13, G06T 17/10, G06T 17/20

(54) **RECOVERING A 2D WALL CENTER LINE FROM A 3D WALL**

(71) Applicant: Dassault Systèmes, 78140 Vélizy-Villacoublay (FR)
(72) Inventor: VOIRIN, Pierre, 13100 Aix en Provence (FR)
(74) Representative: Bandpay & Greuter

(57) **Abstract**

The disclosure notably relates to a computer-implemented method for designing a 2D wall center line from at least one 3D wall of a 3D model representing a building intended to be built. The method comprises obtaining at least one 3D wall, obtaining a wall direction representing the direction of the wall elevation and being a vector, for each 3D wall, retrieving faces having their respective negative scalar with a sense opposite to a sense of the wall direction, for each edge of each of the retrieved faces, identifying one edge among the edges of the retrieved faces, thereby forming a valid pair of edges, for each of the valid pairs having been formed, computing a 2D pair wall center line, and computing the 2D wall center line of the 3D model by merging the computed 2D pair wall center lines of the valid pairs.

## Description

### TECHNICAL FIELD

The disclosure relates to the field of computer programs and systems, and more specifically to a method, system and program for designing a 2D wall center line from at least one 3D wall of a 3D model representing a building intended to be built.

### BACKGROUND

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behaviour of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

CAD/CAE/CAM can provide solutions dedicated to the design and/or management and/or construction of buildings. For example, concrete wall pouring can be planed, e.g., the software solution describes which section of the wall will be poured on each day and what quantity of concrete is needed. To that aim, the software solution relies on "wall base lines" representing the wall to be built. A wall base line represents the wall by a wireframe element.

The wall base lines are obtained from a 3D geometry of the wall. Especially, a 3D model representing a building intended to be built comprises several 3D walls. However, an initial 3D geometry of a wall is modified many times by the various crafts involved in its construction, so that it is impossible to automatically compute the wall base line from the 3D geometry of the wall. In addition, when the wall 3D geometry is available only as is, without its creation history or base geometry, retrieving the wall base line takes more time and computer 3D design skills, which both are not necessarily available for construction field planers.

Current methodology for recovering wall base lines comprise the steps of i) extracting the side faces of the wall, ii) computing a mid-surface of the extracted faces using some offset technology, iii) projecting the mid-surface on a plane at the bottom of the wall, and iv) repeating these three steps for each wall. This methodology is time consuming, especially for buildings with hundreds of walls, and requests many user inputs in order to correct the output of the methodology.

Within this context, there is still a need for an improved method for designing a 2D wall center line from at least one 3D wall of a 3D model representing a building intended to be built.

### SUMMARY

It is therefore provided a computer-implemented method for designing a 2D wall center line from at least one 3D wall of a 3D model representing a building intended to be built. The method comprises:
- obtaining at least one 3D volume, each 3D volume representing at least one 3D wall, each 3D wall being constructed with faces limited by edges and connected by vertices forming the edges, each face having a normal vector;
- obtaining a wall direction representing the direction of the wall elevation and being a vector;
- for each 3D wall, retrieving faces having their respective negative scalar with a sense opposite to a sense of the wall direction;
- for each edge of each of the retrieved faces, identifying one edge among the edges of the retrieved faces, thereby forming a valid pair of edges representing a 3D wall of the at least one 3D wall of the 3D model;
- for each of the valid pairs having been formed, computing a 2D pair wall center line; and
- computing the 2D wall center line of the 3D model by merging the computed 2D pair wall center lines of the valid pairs.

The method may comprise one or more of the following:
- before the identifying one edge among the edges of the retrieved faces, merging the retrieved faces by removing internal edges, wherein an internal edge is an edge connecting two faces that are in contact one each other, the merged retrieved faces forming a domain;
- each 3D wall has a height representing the wall elevation, a length representing a footprint of the wall on a ground, and a thickness that is smaller than the length divided by two; and wherein, for each face of each 3D wall, any normal vector on the face has a same direction with respect to the wall direction;
- identifying one edge among the edges of the retrieved faces comprises computing a first line passing through the said for each edge of each of the retrieved faces; computing, for each of the other edges of the retrieved faces, a second line passing through the other edges of the retrieved faces; computing an angle between the first line and the second line; if the computed angle is over a predetermined angular tolerance Θ1° and if the computed angle is not comprised between the range [180° ; 180° - Θ1°], discarding the edge of the second line, thereby considering that the edges of the first and second lines are not a valid pair of edges, preferably the predetermined angular tolerance Θ1 has a value comprised between [10° ; 30°], more preferably the predetermined angular tolerance Θ1° has a value of 25°;
- obtaining, for the said for each edge of each of the retrieved faces, a first center point, a first start point and a first end point; obtaining, for each of the other edges of the retrieved faces, a second center point, a second start point and a second end point; and wherein: computing the first line comprises computing the line passing through the first start point and the first end point; and computing the second line comprises computing the line passing through the second start point and the second end point;
- identifying one edge among the edges of the retrieved faces further comprises: computing a distance between the first center point and the other edge of the second center point or computing a distance between the second center point and the other edge of the first center point; if the computed distance is under a predetermined thickness value T1 of the 3D wall, discarding the edge of the second center point, thereby considering that the edges of the first and second center point are not a valid pair of edges, preferably the predetermined thickness value T1 has a value comprised between [1mm ; 5mm], more preferably the predetermined thickness value T1 has a value of 1mm;
- identifying one edge among the edges of the retrieved faces further comprises:
   computing a first distance between the first start point and the second start point;
   computing a second distance between the first start point and the second end point;
   computing a third distance between the first end point and the second start point;
   computing a fourth distance between the first end point and the second end point;
   determining the smallest distance among the first, second, third and fourth distances, thereby obtaining a couple of points comprising the two points with which the smallest distance has been computed; for each point of the couple of points, computing a vector from the point of the couple to the start point or end point of the edge the point of the couple belongs to, thereby obtain two vectors; computing a scalar product between the obtained two vectors; and if the computed scalar product is negative, discarding the edge of the said each of the other edges of the retrieved faces;
- identifying one edge among the edges of the retrieved faces further comprises:
   computing a segment connecting the first center point and the second center point;
   if no intersection is detected between the computed segment and the domain, discarding the edge of the said each of the other edges of the retrieved faces;
- computing a reference minimum distance by summing the determined smallest distance, the first distance, the second distance and a distance between the first center point and the second center point; storing, as valid candidate in a list of valid candidates, the edge of the said each of the other edges of the retrieved faces along with its computed reference minimum distance; and selecting in the list the valid candidate having the smallest computed reference minimum distance, thereby the valid pair of edges;
- identifying one edge among the edges of the retrieved faces further comprises: computing a distance D1 between the first line and the second line; obtaining a length L1 of the edge supporting the first line; obtaining a length L2 of the edge supporting the second line; if the distance D1 is larger than the length L1 and/or the length L2, discarding the edge of the first line and the edge of the second line, thereby considering that the edges of the first and second lines are not a valid pair of edges;
- computing the 2D pair wall center line comprises: computing a first segment between the first start point and the second start point, a second segment between the first end point and the second end point; computing a first middle point of the first segment and a second middle point of the second segment; computing a segment connecting the first middle point with the second middle point, thereby obtaining the 2D pair wall center line of the valid pair; computing an average wall segment pair thickness from each wall segment pair thickness of each of the 2D pair wall center lines; comparing a length of the 2D pair wall center line of each valid pair with the computed average wall segment pair thickness; and if the length of one of the 2D pair wall center lines is smaller than the computed average wall segment pair thickness, discarding the 2D pair wall center line;
- at least one 3D wall comprises at least one nonplanar face, the computing the 2D pair wall center line comprising: computing a first segment between the first start point and the second start point, a second segment between the first end point and the second end point; computing a first middle point of the first segment and a second middle point of the second segment; computing an isoparametric curve connecting the first middle point and the second middle point, thereby obtaining the 2D pair wall center line of the valid pair.
- computing the 2D pair wall center line of the 3D model further comprises: retrieving a lowest vertex among the vertices of the 3D wall in the wall direction; computing a plane comprising the lowest vertex and having the wall direction as a normal; projecting each 2D pair wall center line on the computed plane, the projection being performed according to the wall direction, thereby obtaining a set of projected 2D pair wall center lines; merging the projected 2D pair wall center lines; and on the projected 2D pair wall center lines that have been merged, removing vertices are a start point and/or an end point and/or not on a sharp angle, thereby obtaining the 2D wall center line of the 3D model;
- the projecting each 2D pair wall center line on the computed plane further comprises: detecting an overlap between at least two projected 2D pair wall center lines; if the whole of one projected 2D pair wall center overlaps the other projected 2D pair wall center: selecting one of a closest start point and end point of the at least two projected 2D pair wall center lines that overlap; computing a first cutting line going through the closest start point and normal to the projection plane, and a second cutting line going through the closest end point and normal to the projection plane; cutting the other projected 2D pair wall center using the two cutting lines; and sewing the one projected 2D pair wall center with the other projected 2D pair wall center; if part of one projected 2D pair wall center overlaps the other projected 2D pair wall center: selecting one of a closest start point or end point of the at least two projected 2D pair wall center lines that overlap; computing a first cutting line going through the closest start point and normal to the projection plane; cutting the other projected 2D pair wall center using the cutting line; and sewing the one projected 2D pair wall center with the other projected 2D pair wall center;
- for a domain: retrieving the 2D wall center lines of the 3D model start points and end points, and their respective tangent directions; for each start point: computing a semi-infinite line using the start point as the beginning of the line and having the tangent direction of the start point as its own direction; computing an intersection point of the semi-infinite line with the 2D wall center line of the 3D model; computing a distance between the intersection point and the start point; if the computed distance is smaller than an average thickness, splitting the semi-infinite line, thereby connecting the start point and the intersection point with a segment; for each end point: computing a semi-infinite line using the end point as the beginning of the line and having the tangent direction of the start point as its own direction; computing an intersection point of the semi-infinite line with the 2D wall center line of the 3D model; computing a distance between the intersection point and the end point; if the computed distance is smaller than the average thickness, splitting the semi-infinite line, thereby connecting the end point and the intersection point with a segment; computing the 2D wall center line of the 3D model by merging the computed 2D pair wall center lines of the valid pairs and the computed segments.

It is further provided a computer program comprising instructions for performing the method.

It is further provided a computer readable storage medium having recorded thereon the computer program.

It is further provided a system comprising a processor coupled to a memory and a graphical user interface, the memory having recorded thereon the computer program.

### BRIEF DESCRIPTION OF THE DRAWINGS

Non-limiting examples will now be described in reference to the accompanying drawings, where:
- FIG. 1 shows a flowchart of an example of the method;
- FIG. 2 shows an example of a graphical user interface of the system;
- FIG. 3 shows an example of the system;
- FIGS. 4 to 37 show examples of the method.

### DETAILED DESCRIPTION

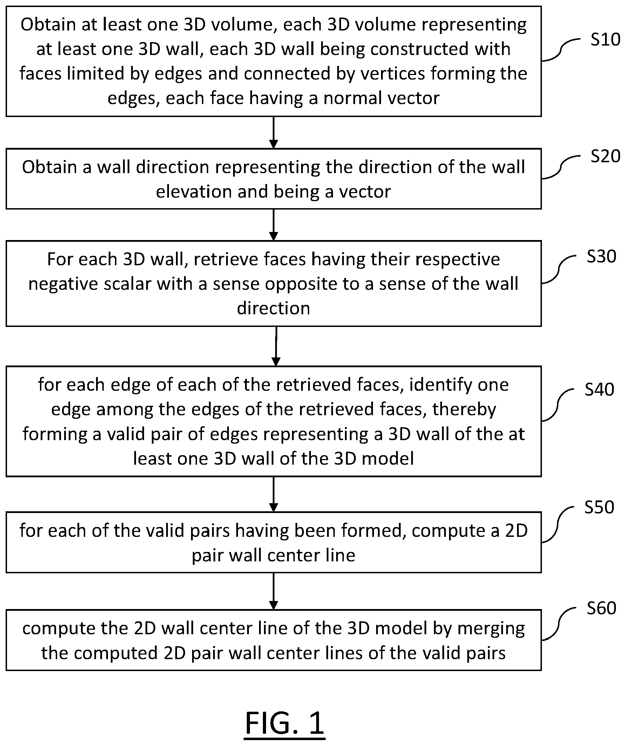

With reference to the flowchart of FIG. 1, it is proposed a computer-implemented method for designing a 2D wall centre line from at least one 3D wall of a 3D model representing a building intended to be built. The method comprises obtaining at least one 3D volume, where each 3D volume represents at least one 3D wall. Each 3D wall is built with faces limited by edges and connected by vertices forming the edges, and each face has a normal vector. The method further comprises obtaining a wall direction representing the direction of the wall elevation and being a vector. The wall direction is the same for all the 3D walls. For each 3D wall, faces are retrieved; the retrieved faces have their respective negative scalar with a sense opposite to a sense of the wall direction. The method also comprises performing, for each edge of each of the retrieved faces, the identifying one edge among the edges of the retrieved faces, thereby forming a valid pair of edges representing a 3D wall of the at least one 3D wall of the 3D model. Next, the method further comprises computing a 2D pair wall centre line for each of the valid pairs having been formed. Then, the method comprises computing the 2D wall centre line of the 3D model by merging the computed 2D pair wall centre lines of the valid pairs.

Such method improves the design of a 2D wall center line from at least one 3D wall of a 3D model representing a building intended to be built. Notably, the method is fully automatic and does not need any user input (e.g. correction) after the parameter input steps. In addition, the method does not need history regarding the 3D walls; the 2D wall center line of the 3D model is computed without requiring the knowledge of any past operation that might have been performed on the 3D walls, e.g. on the geometry of the 3D wall.

Further advantage will be more apparent in the following description. Notably, through the wireframe algorithm, many walls can be managed all together, and the openings in the wall are taken into account. The wireframe algorithm is also much faster than the standard surface-based background art.

The present invention has a direct impact on the construction of a wall: the precise quantity of concrete that is needed to pour a wall can be determined, thus avoiding situations in which not enough concrete is made available during the pouring process, which can lead to weakening the wall in construction.

The method is computer-implemented. This means that steps (or all the steps) of the method are executed by at least one computer, or any system alike. Thus, steps of the method are performed by the computer, possibly fully automatically, or, semiautomatically. In examples, the triggering of at least some of the steps of the method may be performed through user-computer interaction, e.g. the steps of input parameters. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

The method generally manipulates 3D modeled objects, the 3D volumes each representing at least one 3D wall. A modeled object is any object defined by data stored e.g. in the database. By extension, the expression "modeled object" designates the data itself. According to the type of the system, the modeled objects may be defined by different kinds of data. The system may indeed be any combination of a CAD system, a CAE system, a CAM system, a PDM system and/or a PLM system. In those different systems, modeled objects are defined by corresponding data. One may accordingly speak of CAD object, PLM object, PDM object, CAE object, CAM object, CAD data, PLM data, PDM data, CAM data, CAE data. However, these systems are not exclusive one of the other, as a modeled object may be defined by data corresponding to any combination of these systems. A system may thus well be both a CAD and PLM system, as will be apparent from the definitions of such systems provided below.

By CAD system, it is additionally meant any system adapted at least for designing a modeled object on the basis of a graphical representation of the modeled object, such as CATIA. In this case, the data defining a modeled object comprise data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones. The typical size of a file representing a modeled object in a CAD system is in the range of one Megabyte per part. And a modeled object may typically be an assembly of thousands of parts.

In the context of CAD, a modeled object may typically be a 3D modeled object, e.g. representing a product such as a part or an assembly of parts, or possibly an assembly of products. By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

The 3D modeled object may represent the geometry of a product, a wall, to be manufactured (that is constructed) in the real world subsequent to the completion of its virtual design with for instance a CAD software solution or CAD system. A CAD software solution allows the design of products in various and unlimited industrial fields, including: aerospace, architecture, construction, consumer goods, high-tech devices, industrial equipment, transportation, marine, and/or offshore oil/gas production or transportation. The 3D modeled object manipulated by the method thus represent an industrial product, a wall.

A CAD system may be history-based. In this case, a modeled object is further defined by data comprising a history of geometrical features. A modeled object may indeed be designed by a physical person (i.e. the designer/user) using standard modeling features (e.g. extrude, revolute, cut, and/or round) and/or standard surfacing features (e.g. sweep, blend, loft, fill, deform, and/or smoothing). Many CAD systems supporting such modeling functions are history-based system. This means that the creation history of design features is typically saved through an acyclic data flow linking the said geometrical features together through input and output links. The history-based modeling paradigm is well known since the beginning of the 80's. A modeled object is described by two persistent data representations: history and B-rep (i.e. boundary representation). The B-rep is the result of the computations defined in the history. The shape of the part displayed on the screen of the computer when the modeled object is represented is (e.g. a tessellation of) the B-rep. The history of the part is the design intent. Basically, the history gathers the information on the operations which the modeled object has undergone. The B-rep may be saved together with the history, to make it easier to display complex parts. The history may be saved together with the B-rep in order to allow design changes of the part according to the design intent.

By PLM system, it is additionally meant any system adapted for the management of a modeled object representing a physical manufactured product (or product to be manufactured). In a PLM system, a modeled object is thus defined by data suitable for the manufacturing of a physical object. These may typically be dimension values and/or tolerance values. For a correct manufacturing of an object, it is indeed better to have such values.

By CAM solution, it is additionally meant any solution, software of hardware, adapted for managing the manufacturing data of a product. The manufacturing data generally includes data related to the product to manufacture, the manufacturing process and the required resources. A CAM solution is used to plan and optimize the whole manufacturing process of a product. For instance, it can provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. Such CAM solutions are provided by Dassault Systèmes under the trademark DELMIA^{®}.

By CAE solution, it is additionally meant any solution, software of hardware, adapted for the analysis of the physical behavior of a modeled object. A well-known and widely used CAE technique is the Finite Element Method (FEM) which typically involves a division of a modeled object into elements which physical behaviors can be computed and simulated through equations. Such CAE solutions are provided by Dassault Systèmes under the trademark SIMULIA^{®}. Another growing CAE technique involves the modeling and analysis of complex systems composed a plurality component from different fields of physics without CAD geometry data. CAE solutions allow the simulation and thus the optimization, the improvement and the validation of products to manufacture. Such CAE solutions are provided by Dassault Systèmes under the trademark DYMOLA^{®}.

PDM stands for Product Data Management. By PDM solution, it is meant any solution, software of hardware, adapted for managing all types of data related to a particular product. A PDM solution may be used by all actors involved in the lifecycle of a product: primarily engineers but also including project managers, finance people, salespeople and buyers. A PDM solution is generally based on a product-oriented database. It allows the actors to share consistent data on their products and therefore prevents actors from using divergent data. Such PDM solutions are provided by Dassault Systèmes under the trademark ENOVIA^{®}.

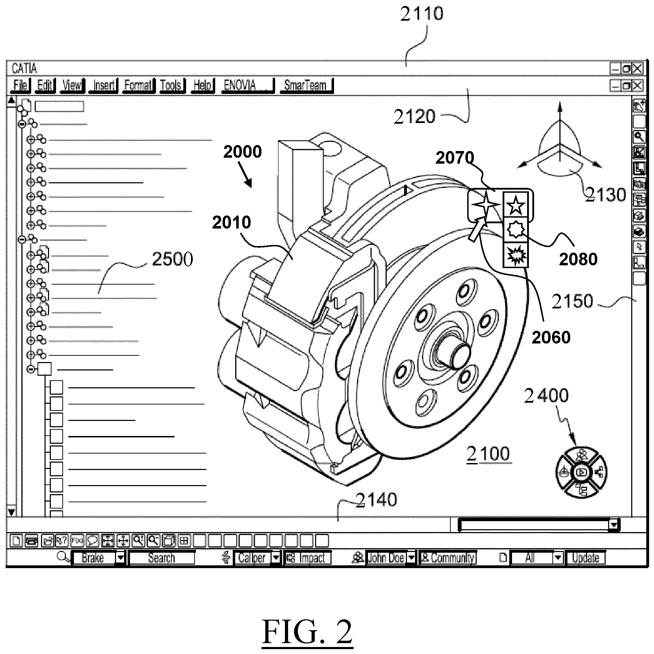

FIG. 2 shows an example of the GUI of the system, wherein the system is a CAD system.

The GUI 2100 may be a typical CAD-like interface, having standard menu bars 2110, 2120, as well as bottom and side toolbars 2140, 2150. Such menu- and toolbars contain a set of user-selectable icons, each icon being associated with one or more operations or functions, as known in the art. Some of these icons are associated with software tools, adapted for editing and/or working on the 3D modeled object 2000 displayed in the GUI 2100. The software tools may be grouped into workbenches. Each workbench comprises a subset of software tools. In particular, one of the workbenches is an edition workbench, suitable for editing geometrical features of the modeled product 2000. In operation, a designer may for example pre-select a part of the object 2000 and then initiate an operation (e.g. change the dimension, color, etc.) or edit geometrical constraints by selecting an appropriate icon. For example, typical CAD operations are the modeling of the punching, or the folding of the 3D modeled object displayed on the screen. The GUI may for example display data 2500 related to the displayed product 2000. In the example of the figure, the data 2500, displayed as a "feature tree", and their 3D representation 2000 pertain to a brake assembly including brake caliper and disc. The GUI may further show various types of graphic tools 2130, 2070, 2080 for example for facilitating 3D orientation of the object, for triggering a simulation of an operation of an edited product or render various attributes of the displayed product 2000. A cursor 2060 may be controlled by a haptic device to allow the user to interact with the graphic tools.

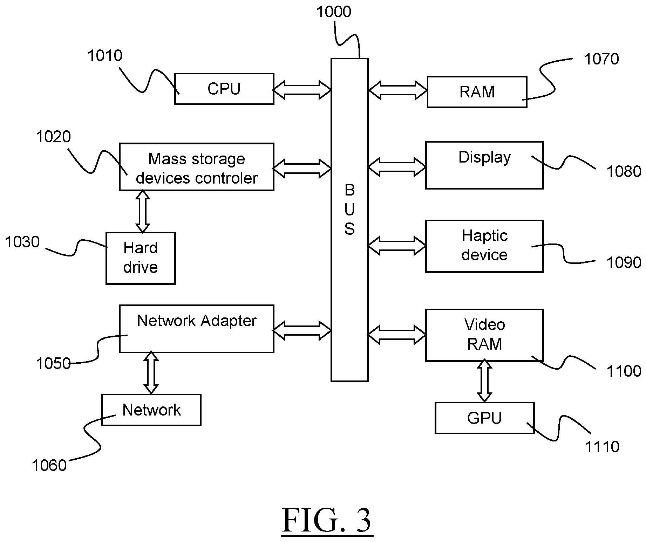

FIG. 3 shows an example of the system, wherein the system is a client computer system, e.g. a workstation of a user.

The client computer of the example comprises a central processing unit (CPU) 1010 connected to an internal communication BUS 1000, a random-access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

"Designing a 2D wall center line from at least one 3D wall of a 3D model representing a building intended to be built" designates any action or series of actions which is at least part of a process of elaborating a 3D modeled object, e.g. a wall. Thus, the method may comprise creating the 3D modeled object from scratch. Alternatively, the method may comprise providing a 3D modeled object previously created, and then modifying the 3D modeled object.

The method may be included in a manufacturing process, which may comprise, after performing the method, producing a physical product corresponding to the modeled object, e.g. building a wall. In any case, the modeled object designed by the method may represent a manufacturing object. The modeled object may thus be a modeled solid (i.e. a modeled object that represents a solid). The manufacturing object may be a product, such as a part, or an assembly of parts. Because the method improves the design of the modeled object, the method also improves the manufacturing of a product and thus increases productivity of the manufacturing process.

Referring back to FIG.1, S10, at least one 3D volume is obtained. "Obtaining" means that the data for representing and/or manipulating the 3D volume are made available to the system that performs the method, e.g. stored on the memory of a CAD system. Each 3D volume represents at least one 3D wall; a 3D wall is an object that will be built. Each 3D wall is constructed with (that is, is comprised of) faces limited by edges and connected by vertices forming the edges. In addition, each face has a normal vector. The normal vector may be obtained with the other data regarding the 3D wall, or it may be computed by the system.

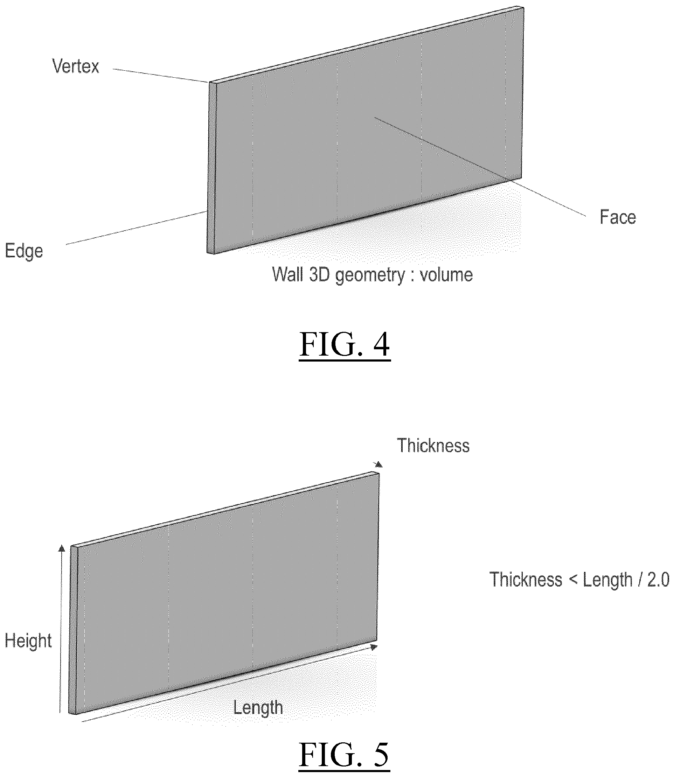

Referring to FIG. 4, is represented a 3D wall as it may be displayed on the GUI shown on FIG. 2. The 3D wall has a geometry that defines a 3D volume and comprises in this example eight vertices, twelve edges and six faces. The volume is delimited by faces, themselves delimited by edges, themselves delimited by vertices.

Referring now to FIG. 5, examples of input parameters of the 3D wall are represented, and comprise a thickness of the 3D wall, a length of the 3D wall and a height of the 3D wall. The definitions of the thickness the 3D wall is self-explicit: thickness is the gap between the two sides of the wall. The height of the 3D wall represents the elevation of the 3D wall. The length of the 3D wall is the length of the footprint of the wall on the ground (as seen by the system and as performed when building the wall).

In examples, the thickness of the wall may be smaller than the length divided by two. This ensures that the 3D wall has the shape of a wall as met in the real world, and is not, e.g. a pillar.

Hence, in an example, each 3D wall may have, as input parameters, a height representing the wall elevation, a length representing a footprint of the wall on a ground, and a thickness that is smaller than the length divided by two, and a face such that any normal vector on the face has a same direction with respect to the wall direction.

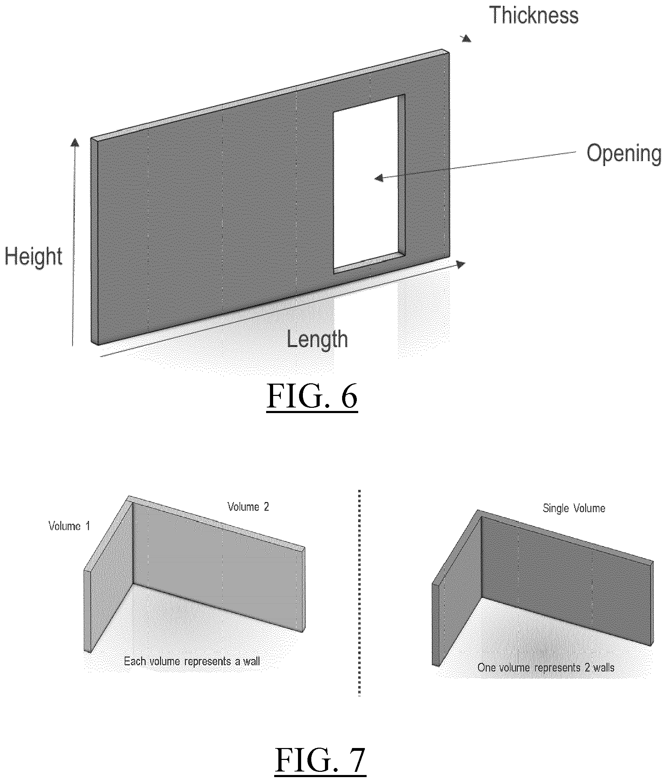

In examples, one or more 3D walls may comprise an opening, as illustrated on FIG. 6. An opening describes the volume needed to insert a door, a window... inside the wall. Geometrically speaking, an opening may be considered as a hole in the wall in the thickness direction. In these examples, an opening may be defined by four planar surfaces, which is the most common case in buildings. In these examples, the opening may be a bull's eye window; a pre-treatment for this type of opening is performed by considering the opening as a cut along a plane normal to the wall direction, the cut being made at the widest part of the bull's eye window.

As illustrated on the left part of FIG. 7, a 3D volume represents one 3D wall; here two volumes are shown, and each represents a 3D wall. One the right part of FIG. 7, one single 3D volume represents two walls.

Referring back to the flowchart of FIG. 1, S20, a wall direction is obtained. The wall direction represents the direction of the wall elevation and is a vector. In examples, one single wall direction may be obtained for all the 3D volumes; in practice, the walls of a building have all the same wall elevation. In examples, a wall direction may be provided for one or more (but not all) 3D volumes; in this situation, the next steps of the method will use the wall direction associated with the one or more (but not all) 3D volumes when performing operations (e.g. computations) on the 3D walls of the 3D volumes. Having one single wall direction or two or more wall directions does not change the method of the present invention. The wall direction is(are) obtained, e.g. provided with the data for representing and/or manipulating the 3D volume(s). In examples, the wall direction may be inferred from the geometry of the 3D volumes, e.g. it is automatically detected from the 3D volumes.

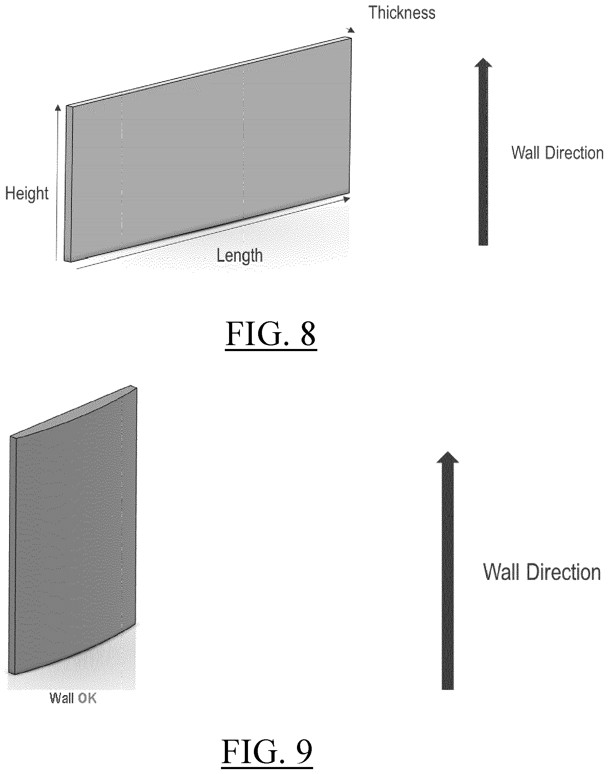

The wall direction may be used for defining (or inferring) the direction of the height of the 3D wall. In this situation, the other dimensions of the 3D wall, the "Length" and the "Thickness", are defined with respect to the wall direction, as illustrated on FIG. 8.

It is to be understood that step S10 may be carried out before S20, and inversely, or concomitantly.

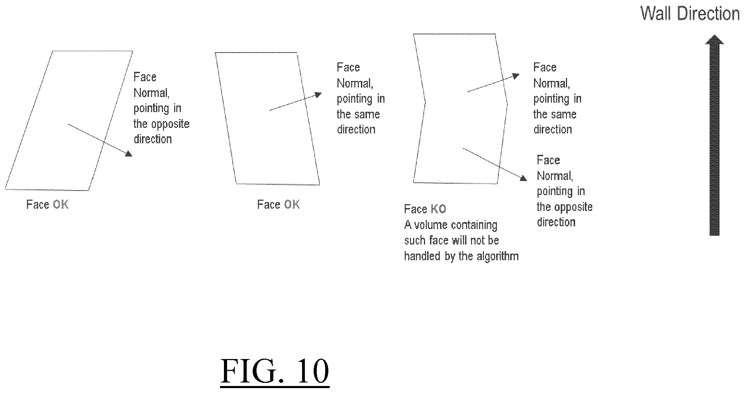

It is now discussed further examples of 3D walls provided in input of the method (obtained), and the use of the normal vectors associated with each face of the 3D walls, and the wall direction. In examples, only walls containing no "face undercut" in the specified wall direction may be obtained. That is to say that for every face of the 3D wall geometry, one face should not include both a normal vector pointing in the same direction as the wall direction and another normal vector pointing in the opposite direction. This is for example illustrated on FIG. 10, where both faces on the left and the middle of the figure have any normal vector pointing to the same direction. This is not the case for the face represented on the right of the FIG. 10 where two normal vectors have an opposite direction. If walls contain "face undercut", the method can be stopped, or the face may be ignored by the algorithm. If ignored, a warning may be shown to the users in order to inform them of the presence of at least one "face undercut".

A 3D wall may contain non-planar faces, as long as they respect the previous rules. This is illustrated on FIG. 9 where any normal vector on the non-planar face will have a same direction.

The inputs of the algorithm having been set forth in reference to S10 and S20, step S30 is now discussed. The following computations are carried out for each 3D wall. The 3D wall may be represented by one volume, or two or more 3D walls may be part of one volume, as discussed in reference to FIG. 7.

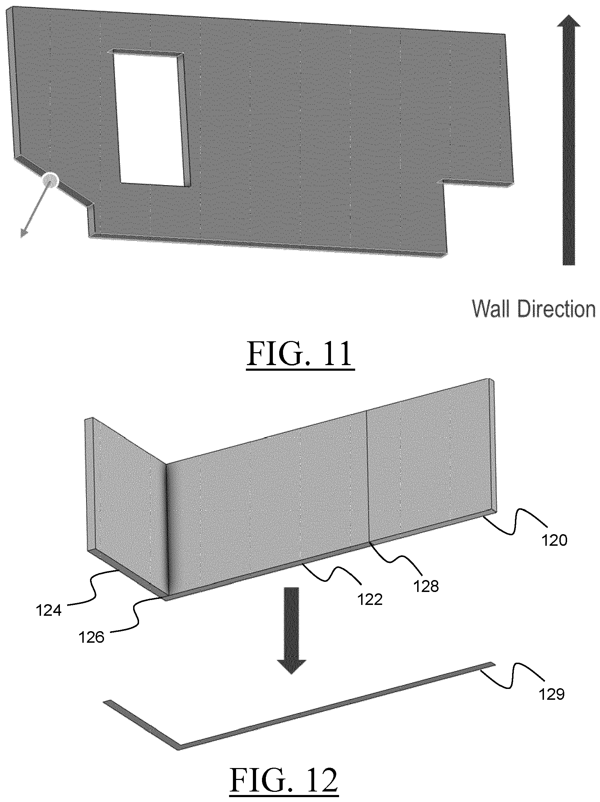

For each 3D wall, the faces defining the wall are retrieved, where each retrieved face has a respective negative scalar with a sense opposite to a sense of the wall direction. This allows to define which faces of the wall are facing "downward", that is facing to the ground. Those faces may be stored in a list named "Downward Faces". FIG. 11 shows an example of four identified faces with a negative scalar with a sense opposite to a sense of the wall direction.

In examples, S30 may be implemented as follows. For each face of the obtained 3D walls, a center point of the face is computed, e.g. the barycenter of the face. Then, the normal vector of the face is evaluated, pointing outside of the volume. If the scalar product between this vector and the wall direction is negative, the face is kept, e.g. it may be added to a list of "Downward Faces".

In examples, the following treatment may be performed on the faces that have been added to the list of "Downward Faces", that is on the retrieved faces of the 3D walls. The retrieved faces may be "sewed" together, so that continuous faces are merged into one single face. This operation allows removing internal edges and simplifying the external edges.

This is illustrated on FIG. 12 that shows three 3D wall, one face 120, 122, 124 having been retrieved for each. The three retrieved faces are merged by removing internal edges 126, 128. An internal edge is an edge connecting two faces that are in contact one each other. An internal edge is therefore shared by two faces. Once the faces have been merged, they form a new single face that is referred to as a domain 129. It is to be understood that the domain is formed of a set of connected edges that all together enclose the new single face; this set of connected edges is also referred to as belt.

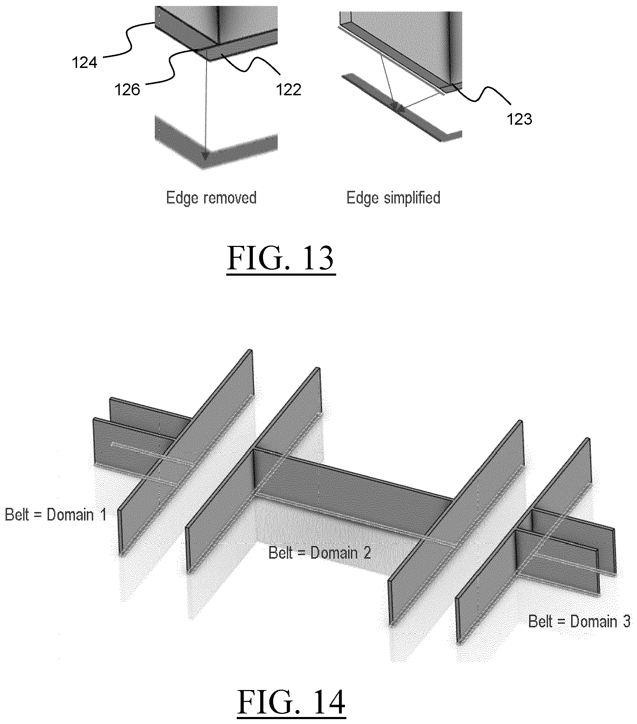

FIG. 14 shows three domains, namely Domain 1, Domain 2 and Domain 3, and each domain comprises a set of edges forming a belt.

FIG. 13 is a closed-up view of the faces 122, 124 and the internal edge 126. The left side of the figure shows a part of the domain as a result of the removal of the internal edge 126. The right side shows an example of simplified edge of the belt obtained as a result of the removal of the internal edge 126. A simplified edge may be obtained by merging two consecutive and connected edges, e.g. by removing the point (vertex) of the internal edge 126 that is shared with one edge belonging to the belt. For example, the vertex 123 is kept as it is shared by two edges forming the belt (and also shared with the internal edge 126).

Back to FIG. 1, at S40, pairs of valid edges are identified. A pair of valid edges is a pair of edges on each side of one piece of the 3D wall. The so-called valid edges contribute to the length of the wall, and not the thickness. In other words, a pair of valid edges comprises the edges of a 3D wall contributing to the footprint of the 3D wall on the ground. From a pair of valid edges, it is possible to determine the footprint of the 3D wall.

To find those pairs of valid edges, each face of each of the retrieved faces is tested as follows. For each edge of one of the retrieved faces - this edge is also referred to as "reference edge" when tested - one edge is identified among the other edges of the retrieved faces so that the reference edge and the edge selected among the other edges from a valid pair of edges representing a 3D wall of the at least one 3D wall of the 3D model. The output of S40 provides pairs of edges of the domain, and each pair of edge defines a 3D wall. Hence, each edge of the retrieved faces is tested (that is, it is a reference edge) with the other edges.

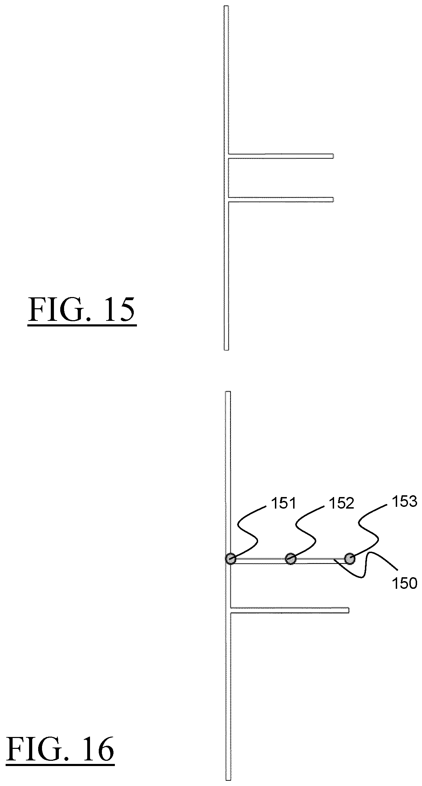

Finding these pairs may be complex, especially when the building to be constructed has many small rooms, nooks and crannies, closets... Examples of algorithms are now discussed. One or more of these examples may be combined. The following examples will be discussed in reference to the example of domain of FIG. 15.

In examples, the identifying one edge among the other edges of the retrieved faces may rely on an angular comparison between the two edges. An angular tolerance is used for that purpose. The angular tolerance defines a maximum angle under which two segments can be matched together to define a valid pair of edges representing a 3D wall. The angular tolerance, noted Θ₁, may be provided at the beginning of the method, before S30, or at the beginning of the execution of the present example. The value of the angular tolerance may be provided upon user action or automatically with a default value. In these examples, a good value for this parameter may be comprised in the range [10° ; 30°]. In an example, the angular tolerance may have a value substantially equal to 25°; this value shows the bests results in experiments made by the inventor.

In these examples, two lines may be computed, one for the reference edge and one for each of the other edges of the retrieved face being tested. Thus, is computed a first line passing through the said for each edge of each of the retrieved faces (the reference edge); is also computed, for each of the other edges to be tested of the retrieved faces, a second line passing through the other edge that is tested. It is to be understood that a second line is computed for each other edges. The expression "passing through" means that the first line is parallel to the reference edge and the second line is parallel to the other edge that is tested. Hence, "passing through" can be interpreted as the first line and the second line are merged with their respective edge, or are substantially merged with (e.g. in the vicinity of the edge) and parallel to the edge.

Then, an angle may be computed between the first line and the second line.

Next, it may be determined whether the computed angle is over (larger than) the predetermined angular tolerance Θ₁° and if the computed angle is not comprised between the range [180° ; 180° - Θ₁°]. If yes, the edge of (associated with) the second line is discarded. Therefore, the systems knows that the edges of (associated with) the first and second lines are not a valid pair of edges.

Still in examples of the angular comparison between the two edges, points (that is vertices) may be obtained on the reference edge. A first point located at the center of the reference edge referred to as first center point, one of the two vertices of the reference edge is selected as the first start point, and the second one is selected as the first end point. This is illustrated on FIG.16 with an edge 150 of a face of a 3D wall of the domain of FIG. 16 that has been chosen as the reference edge. The edge comprises two vertices 151, 153 that are selected respectively as the first start point and first end point. At center of the edge 150 is added a center point 152. It is to be understood that the center point 152 is not a new vertex of the edge - the original edge 150 is not subdivided-. The start, end and center points are logical points used for performing the angular comparison.

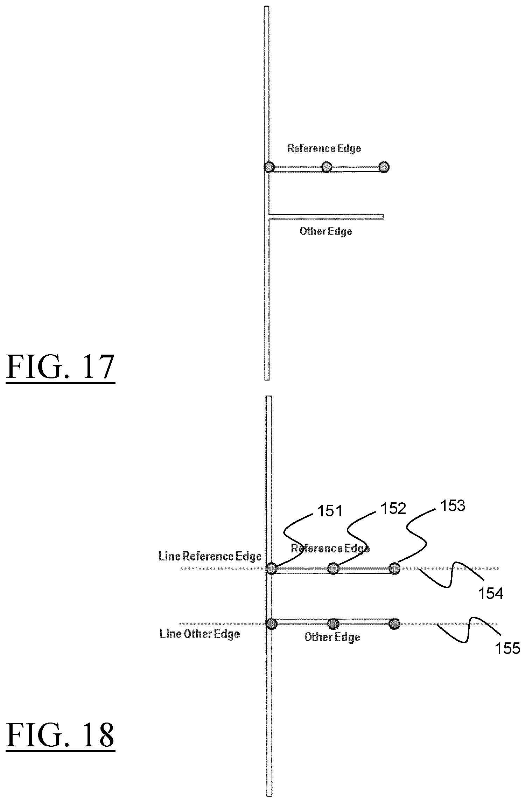

For each of the other edges of the retrieved faces, a second center point, a second start point and a second end point are obtained. This is performed the same way as for the edge 150, as illustrated on FIG. 17. It is to be understood that for each edge of the other edges of the retrieved faces (the edges that will be tested for determining if one of them can form with the reference edge a valid pair of edges) respective a second start point and a second end point are obtained.

Then, as shown in FIG. 18, a first line 154 is computed. The first line is computed so that it comprises the first start point 151 and the first end point 153. It is to be understood that the first line also comprises the center point 152 of the edge 150. The first line thus passes through the first start point and the first end point.

Similarly, still in reference to FIG. 18, a second line 155 is computed, which passes through the second start point and the second end point.

Next, an angle is computed between the first and the second lines in order to decide to keep or discard the other edge, as discussed hereinabove.

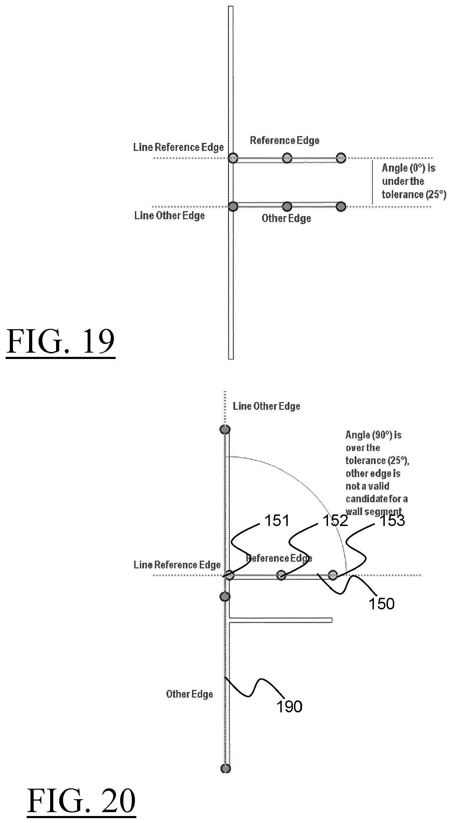

As illustrated on FIG. 19, the value of the angle is 0°, which is under the predetermined angular tolerance Θ₁° with a value of 25° in this example. Both edges form a valid pair of edges.

In the example of FIG. 20, the reference edge 150 is tested with another edge 190 for which respective second start point, second end point and second center point have been computed. The value of the angle is 90°, which is above the predetermined angular tolerance Θ₁° (25° in this example) and not comprised in the range [180° ; 180° - Θ₁°], involves the discarding of the edge 190.

The use of the start, center and end points ensures that the computed line is merged with the edge. In addition, further algorithms that will be discussed rely on these particular points.

It is to be understood that the selection of what vertex of an edge will be the start or end point is an arbitrary choice and does not change the result of the result of the algorithm.

In examples, the identifying one edge among the other edges of the retrieved faces may rely on the thickness of the wall. In these examples, a distance may be computed between the first center point of the reference edge and the other edge of the second center point. Alternatively, the distance may be computed between the second center point of the other edge and the reference edge associated with the first center point. In other words, the distance is measured between one of the two centered points and the opposite edge. If the computed distance is under a predetermined thickness value T₁ of the 3D wall, the edge of (associated with) the second center point is discarded. Therefore, the systems knows that the edges of (associated with) the first and second lines do not form a valid pair of edges.

The measure of the distance may be performed by using an orthogonal line starting from the center point of one of the two edges and crossing the opposite edge, the measure being taken between the center point and the crossing point.

In these examples, the predetermined thickness value T₁ may have a value comprised between [1mm ; 5mm], more preferably the predetermined thickness value T₁ has a value of 1mm; this value shows the bests results in experiments made by the inventor.

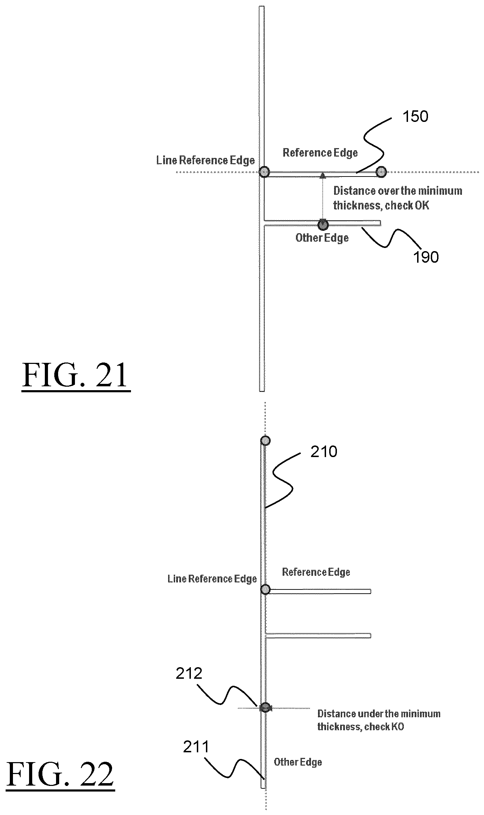

FIG. 21 shows an example where the distance is measured between the center edge of the other edge 190 and the reference edge 150. The distance measured being over the predetermined thickness value T₁, the edge 190 is kept. The edges 150 and 190 thus form a valid pair of edges.

FIG. 22 shows an example where the distance is measured between the center the reference edge 210 and the center point 212 of another edge 211 of the face of the 3D wall. As the distance measured (0mm) is under the predetermined thickness value T₁, the edge 211 is discarded.

In examples, the identifying one edge among the other edges of the retrieved faces may rely on the orientation of the reference edge and the other edge. In these examples, the tested edges comprise start points, end points and center points: the reference edge comprises first start, end and center points; the other edge comprises second start, end and center points. Four distances are computed between the reference edge and the other edge among the edges of the faces of the 3D walls, namely:
- a first distance between the first start point and the second start point;
- a second distance between the first start point and the second end point;
- a third distance between the first end point and the second start point; and
- a fourth distance between the first end point and the second end point.

The four distances having been computed, the smallest distance between these four distances is determined. The two points with which the smallest distance has been calculated form a couple of points.

Next, a vector is computed for each point of the couple of points. A first vector starts from a first point of the two points of the couple of points to the start point or end point of the edge the first point of the couple belongs to. A second vector start from the second point of the couple of points to the start point or end point of the edge the second point of the couple belongs to. As a result, two vectors are obtained.

Then, a scalar product is computed between the obtained two vectors. If the scalar product is negative, the other edge is discarded; the reference edge and the other edge do not form a valid pair of edges representing a 3D wall of the at least one 3D wall of the 3D model.

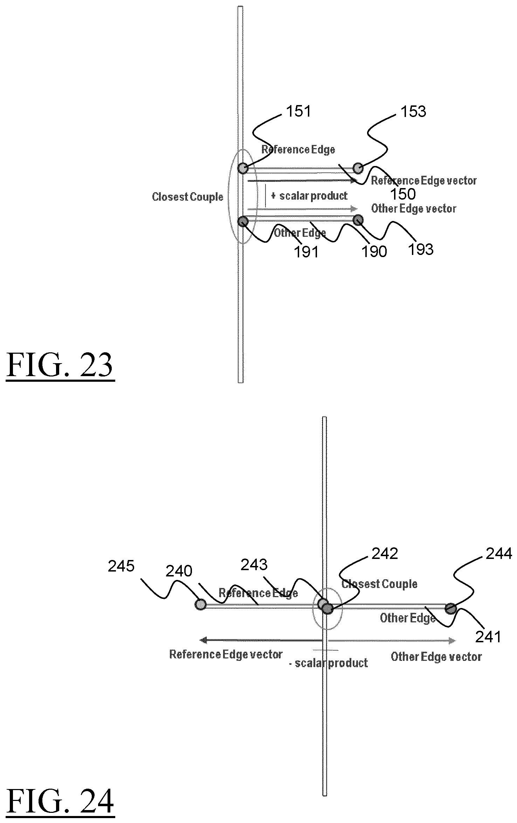

FIG. 23 shows an example of the identification of one edge as discussed. Two edges are tested to determine whether they form together a pair of valid edges, namely the reference edge 150 and the other edge 190. The couple of points 151, 191 has the closest distance. In this example, the points 153, 193 have a distance that is equal to the one measured for the couple of points 151, 191; when such situation occurs, one of the two potential couples of points is selected, here the couple of points 151, 191. Two vectors are obtained. The first one extends from the point 151 to the point 153, and the second one extends from the point 191 to the point 193. The scalar product is positive, and therefore the other edge 190 is kept: the edges 150 and 190 form a pair of valid edges.

FIG. 24 shows another example of the identification of one of the other edges relying on the orientation of the compared edges. In this example the reference edge is 240 and the tested edge is 241. Points 243 and 242 form the couple of points. The vector of the reference edge 240 extends from the point 243 to 245, and the vector of the tested edge extends from the point 242 to 244. The directions of the two vectors are opposite and the scalar product is negative. The other edge 241 is discarded as a consequence.

In examples, the identifying one edge among the other edges of the retrieved faces may rely on the detection of the presence of a part of the domain between the tested edges. In these examples, the tested edges comprise at least center points; being understood that they may additionally comprise start and end points. In these examples, a segment connecting the first center point of the reference edge and the second center point of the other edge is computed. Next, if no intersection between the computed segment and the domain is detected, then the other edge is discarded, and the two edges do not form a valid pair of edges.

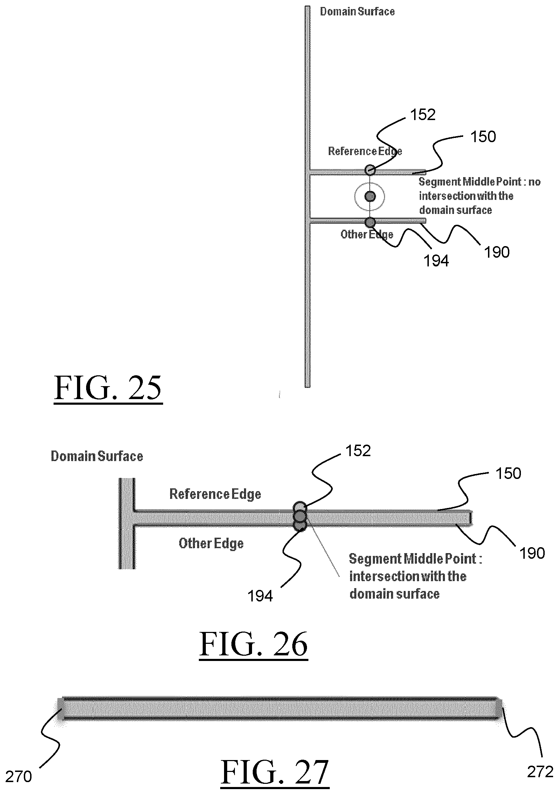

FIG. 25 shows an example of an identification relying on the detection of the presence of a part of the domain between the tested edges. The edge 150 is the reference edge and the edge 190 is the other edge. Both edges have a center point, respectively 152 and 194. A segment connecting the center points 152, 194 is computed and it does not intersect with the domain. Edge 190 is therefore discarded.

FIG. 26 shows another example of an identification relying on the detection of the presence of a part of the domain between the tested edges. The reference edge 150 and the other edge 190 are located on either side of the 3D wall: the segment connecting the center points 152, 194 intersects the domain. The other edge 190 is not discarded.

In these examples, the detection may comprise detecting if a middle point of the segment connecting the first center point of the reference edge and the second center point of the other edge is computed. This improves intersection detection.

In examples, a reference minimum distance may be computed. The reference minimum distance is obtained by summing:
- the smallest distance that is obtained the same manner as discussed in reference to FIGs. 23 and 24: four distances are computed between the reference edge and the other edge among the edges of the faces of the 3D walls:
   - a first distance between the first start point and the second start point;
      -- a second distance between the first start point and the second end point;
      -- a third distance between the first end point and the second start point; and
      -- a fourth distance between the first end point and the second end point;
and the smallest (shortest) distance between these four distances is determined;
- the first distance;
- the second distance; and
- a distance between the first center point and the second center point.

Once the sum has been computed, the other edge is stored as valid candidate in a list of valid candidates along with its reference minimum distance previously computed. Finally, one of the other edges is selected in this list, the one with the smallest reference minimum distance. The reference edge and the selected other edge form the valid pair of edges.

In examples, the identifying one edge among the other edges of the retrieved faces may comprise filtering out edges pairs that delimit the wall in the thickness direction, as illustrated on FIG. 27. Indeed, the combination of one or more of the previous algorithms may lead to the identification of the edges 270, 272 as forming a valid pair of edges. It may be required to discard these pairs of edges, that is to invalidate these pairs of edges.

The identification of the pairs of edges to unvalidated may comprise computing a distance D1 between the first line and the second line. This amounts to say that a distance D1 between the reference edge and the other edge is computed. It is to be understood that the first and second lines (or edges) may not be parallel so that the distance D1 may vary depending on the location of the measurement; the distance D1 may be an average of several measurements.

Next, a length L1 of the edge supporting the first line and a length L2 of the edge supporting the second line are obtained.

The following is then carried out. If the distance D1 is larger than the length L1 and/or the length L2, then the edge of the first line and the edge of the second line are discarded; the edges of the first and second lines are considered as being not a valid pair of edges.

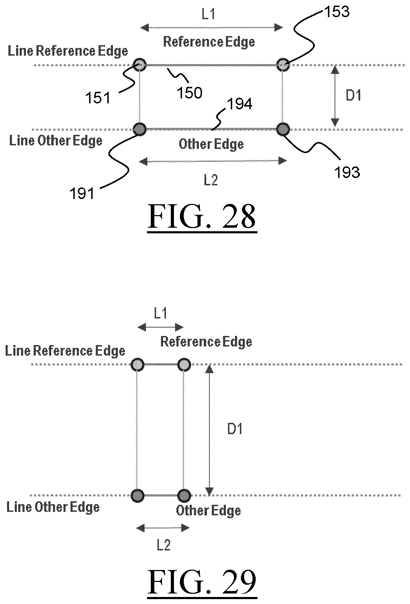

This is illustrated on FIG. 28. The reference edge 150 comprises two vertices 151, 153, that coincide with the start/end points of the edge 150. The other edge 194 comprises two vertices 191, 193, that coincide with the start/end points of the edge 190. Are obtained a distance L1 between the vertices 151, 153 and a distance L2 between the vertices 191, 193. A distance D1 between the edges 150, 190 is computed. The distance D1 may be obtained as discussed in reference to the examples for which the identifying one edge among the other edges of the retrieved faces may rely on the thickness of the wall. Alternatively, D1 may be measured between the first line and the second line, where the first line passes through the first start point and the first end point of the reference edge 150, the second line passes through the second start point and the second end point of the other edge 190. As D1 is smaller than L1 and/ L2, the edges 150, 191 for a valid pair of edges.

FIG. 29 illustrates a reverse example of the one of FIG. 28. The measured distance D1 is larger than the distances L1 and/or L2. Thus, the reference edge and the other edge are not valid pairs of edges.

At this step of the method, one or more algorithms for identifying, for each edge of each of the retrieved faces, one edge among the edges of the retrieved faces, thereby forming a valid pair of edges representing a 3D wall of the at least one 3D wall of the 3D model, have been executed. In an example, all these algorithms are combined and carried out in the same order in which they have been presented.

Referring back to FIG. 1, S50, center line is computed for each valid pair that have been previously formed is now discussed.

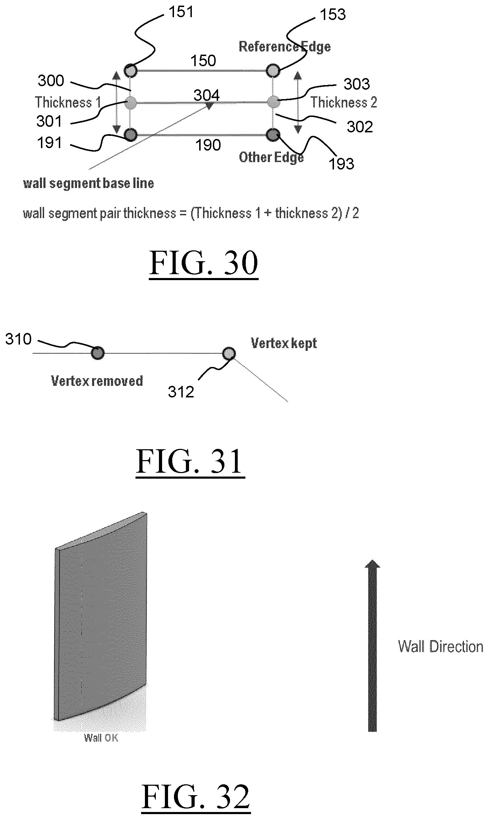

Examples of computation of the 2D pair wall center lines are now discussed in reference to FIG. 30. A first segment 300 may be computed between the first start point 151 of the reference edge 150 and the second start point 191 of the other edge 190. A second segment 302 may be computed between the first end point 153 of the reference edge 150 and the second end point 193 of the other edge 190. The computing of the first and second segments depends on the arbitrary selection of which point, for each edge, is the start/end point. Hence, and alternatively, the first segment 300 may be computed by selecting one 151 of the two vertices of the reference edge 150, determining the closest vertex of the other edge (191 in this example), and the same for the second vertex 153 of the reference edge 150 for computing the second segment 302.

The two segments having been computed, a first middle point 301 of the first segment may be computed and a second middle point 303 of the second segment may be computed.

Next, a segment 304 that connects the first middle point 301 with the second middle point 303 may be computed. The segment 304 is the 2D pair wall center line of the valid pair.

In these examples of computation of the 2D pair wall center lines, the following verifications may be carried out in order to discard invalid pairs of small edges that may be still present. This is performed once all the 2D pair wall center lines of the valid pairs have been computed.

An average wall segment pair thickness is computed from each wall segment pair thickness of each of the 2D pair wall center lines. The wall segment pair thickness of a 2D pair wall center line is obtained by computing the average length of the first 301 and second 303 segments.

The wall segment pair thickness of each of the 2D pair wall center lines having been obtained, the length of each valid pair is compared to the average wall segment pair thickness. This comparison having been performed, if the length of one of the 2D pair wall center lines is smaller than the computed average wall segment pair thickness, then the 2D pair wall center line is discarded. Invalid pairs of small edges are thus filtered and removed.

Referring back to FIG. 1, S60, the 2D wall center line of the 3D model is computed. This is performed by merging the 2D pair wall center line that have been computing; being understood that the 2D pair wall center lines that have been discarded are not part of the process of merging. Merging means that two consecutive 2D wall center line are connected or sewed, thus forming the belt of the domain.

In examples, the computing the 2D pair wall center line of the 3D model may further be performed on a plane on which the 2D pair wall center lines are projected, thus ensuring a correct definition of a domain.

In these examples, a lowest vertex among the vertices of the 3D wall in the wall direction is retrieved. Here the lowest vertex is determined with respect to the wall direction representing the direction of the wall elevation and that is a vector.

Once retrieved, a plane comprising the lowest vertex is computed and has the wall direction as a normal. These two parameters are sufficient for computing the plane.

Then, each 2D pair wall center line is projected on the computed plane. The projection is performed according to the wall direction. As a result, all the 2D pair wall center lines are on the plane and form a set of projected 2D pair wall center lines.

Next, the projected 2D pair wall center lines are merged. This is performed as already discussed.

A treatment of vertices is then carried out on the merged (and projected) 2D pair wall center lines. It consists of removing vertices that are a start point and/or an end point and/or not on a sharp angle. A sharp angle is a connection point of two vertices that comprises an angular break, that is, the two edges do not have the same direction of tangency at the point of connection.

FIG. 31 shows projected 2D pair wall center lines. The vertex 310 is removed as it is a start or end point. The vertex 312 is kept as the angle between the two edges connected to the vertex 312 is a sharp angle.

Examples of the invention have been discussed in reference to FIG. 1. The output of the method thus provide the 2D wall center line of the 3D model with a 3D model that represents a building intended to be built. The output can be directly used for the purpose of computing an accurate quantity of concrete for pouring one or several walls of the 3D model. The building of the walls is therefore improved as the wall can be poured in a single operation, without having to wait for further concrete to be delivered. Hence, it is no more necessary to use setting retarder that prevent concrete from dying. In addition, this avoids waste of concrete as the lifespan of concrete leaving the cement plant is limited in time, but also depends on factors including on various factors, including temperature, humidity, harsh environmental conditions, transportation... Engineers and construction professionals need to adhere to proper practices in concrete mixing, transportation, casting, and curing to ensure its durability and long-term performance. The present invention thus contributes to building more durable wall, that is with an improved long-term performance.

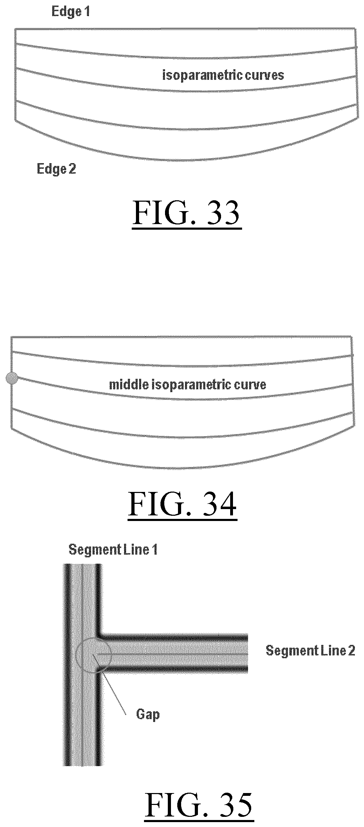

Further examples are now discussed. In examples, at least one 3D wall may comprise at least one nonplanar face, as illustrated in FIG. 32. The examples discussed still apply. The computation of the wall segment base line may be modified with nonplanar faces. Instead of using the mid-line algorithm described in reference to FIG. 30, the algorithm may use a more advanced method to compute the wall segment base line. Instead of creating the middle point on the segments on the start and end points of the edges, a blend surface is created to fill the space defined by the segments and the edges. Blend surfaces are well known by one of ordinary skill in CAD and 3D modeling. The blend surface will create isoparametric curves between the two edges, each isoparametric curve slowly transforming the Edge 1 into the Edge 2 when you get closer to the Edge 2, as illustrated on FIG. 33.

Thus, a first segment between the first start point and the second start point is computed, and a second segment between the first end point and the second end point. Next, a first middle point of the first segment and a second middle point of the second segment are computed. Then, an isoparametric curve is connected. The isoparametric curve connects the first middle point and the second middle point, thereby obtaining the 2D pair wall center line of the valid pair. The resulting isoparametric curve is then considered as the wall segment base line. FIG. 34 shows a resulting isoparametric curve that will be the 2D wall center line of the valid pair of edges of the 3D wall.

Further examples of the projecting each 2D pair wall center line on the computed plane are now discussed. On some pattern, like the "T" wall pattern, some gaps may have been created after projecting the 2D pair wall center line on the 2D plane, as illustrated on FIG. 35. These gaps may need to be filled. An example of implementation is now discussed.

For each domain, or at least for a domain comprising a gap to be filled, are retrieved start points and end points of the 2D wall center lines of the 3D model, and their respective tangent directions.

Then, the following steps are performed for each start point. A semi-infinite line is computed. The semi-infinite line extends from the start point and has for direction the tangent direction of the start point as its own direction. An intersection point of the semi-infinite line with the 2D wall center line of the 3D model is computed. Then, a distance is computed between the computed intersection point and the start point. This distance is compared with an average thickness. The average thickness may be the average wall segment pair thickness discussed in reference to S50. If the computed distance is null or smaller than the average thickness, the semi-infinite line is split into a segment that connects the start point and the intersection point. The gap is therefore filed.

Next, or concomitantly, the same steps are performed for each end point. A semi-infinite line is computed that extends from the end point and has for direction the tangent direction of the end point (as its own direction). An intersection point of the semi-infinite line with the 2D wall center line of the 3D model is computed. Then, a distance is computed between the computed intersection point and the end point. This distance is compared with the average thickness. If the computed distance is smaller than the average thickness, the semi-infinite line is split into a segment that connects the end point and the intersection point.

The segments filing out the gaps having been obtained, the 2D wall center line of the 3D model may be computed. The computation may be performed as discussed in reference to S60, except that the merging uses the computed segments in addition to the computed 2D pair wall center lines of the valid pairs.

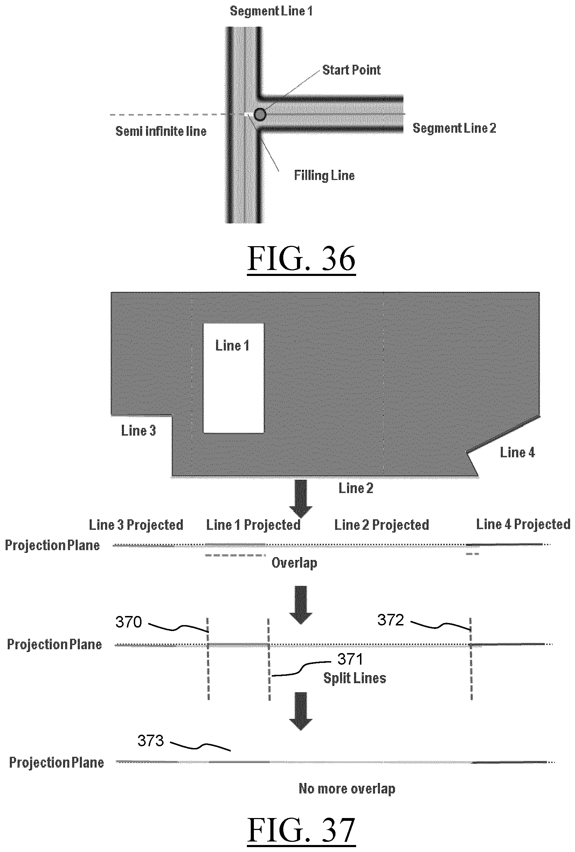

FIG. 36 illustrates the discussed implementation for the case of a starting point.

In examples, the projection on the computed plane of each 2D pair wall center line may comprise situations in which overlaps of projected 2D pair wall center lines exist. This is illustrated on FIG. 37. Four 2D pair wall center lines have been computed for the 3D wall. When projected on the projection plane, two overlaps occur. The whole line 1 overlaps part of the line 2, and part of the line 4 overlaps part of the line 2. To deal with overlaps, in an example, the following algorithm may be used.

Firstly, an overlap is detected between at least two projected 2D pair wall center lines.

Then, two cases may be contemplated. The first one is the whole of one projected 2D pair wall center overlaps the other projected 2D pair wall center. The second one is part of one projected 2D pair wall center overlaps the other projected 2D pair wall center.

If the whole of one projected 2D pair wall center overlaps the other projected 2D pair wall center, the following steps are performed.

One of a closest start point and end point of the at least two projected 2D pair wall center lines that overlaps the other projected 2D pair wall center line is selected. For example, in FIG. 37, the line 1 overlaps the line 2 and the closest start and endpoints t are those of the line 1.

A first cutting line is computed, the first cutting line going through the closest start point and being normal to the projection plane. A second cutting line is also computed, the second cutting line going through the closest end point and being normal to the projection plane. On FIG. 37, the first and second cutting lines are 370, 371.

A cut is performed on the other projected 2D pair wall center using the two cutting lines, e.g. the projected line 2 of FIG. 37 is cut and the part of the projected line 2 comprised between the first 370 and second 371 cutting lines is removed.

Next, the one projected 2D pair wall center is sewed with the other projected 2D pair wall center. For instance on FIG. 37, 137, the projected line 1 is sewed with the remaining two parts of the line 2.

If part of one projected 2D pair wall center overlaps the other projected 2D pair wall center, the following steps are performed.

One of a closest start point or end point of one of the at least two projected 2D pair wall center lines that overlaps the other projected 2D pair wall center line is selected. For example, in FIG 37, the line 4 overlaps the line 2, and the closest start point if the left edge of the line 4.

A first cutting line going through the closest start point and normal to the projection plane is computed. The first cutting line of the closest start point of line 4 is referenced 372 on FIG. 37.

A cutting the other projected 2D pair wall center is performed by using the cutting line. Still in reference to FIG. 37, the line 2 is cut by the cutting line 372. The part of line 2 on the right of the cutting line (that is the part of line 2 that is overlapped by line 4) is removed.

Then, the one projected 2D pair wall center is sewed with the other projected 2D pair wall center. In FIG. 37, the projected line 4 is sewed with the remaining part of the line 2.

## Claims

1. Computer-implemented method for designing a 2D wall center line from at least one 3D wall of a 3D model representing a building intended to be built, comprising:
- obtaining at least one 3D volume, each 3D volume representing at least one 3D wall, each 3D wall being constructed with faces limited by edges and connected by vertices forming the edges, each face having a normal vector;
- obtaining a wall direction representing the direction of the wall elevation and being a vector;
- for each 3D wall, retrieving faces having their respective negative scalar with a sense opposite to a sense of the wall direction;
- for each edge of each of the retrieved faces, identifying one edge among the edges of the retrieved faces, thereby forming a valid pair of edges representing a 3D wall of the at least one 3D wall of the 3D model;
- for each of the valid pairs having been formed, computing a 2D pair wall center line; and
- computing the 2D wall center line of the 3D model by merging the computed 2D pair wall center lines of the valid pairs.

2. The computer-implemented method of claim 1, further comprising, before the identifying one edge among the edges of the retrieved faces:
- merging the retrieved faces by removing internal edges, wherein an internal edge is an edge connecting two faces that are in contact one each other, the merged retrieved faces forming a domain.

3. The computer-implemented method of claim 1 or 2, wherein each 3D wall has a height representing the wall elevation, a length representing a footprint of the wall on a ground, and a thickness that is smaller than the length divided by two; and wherein, for each face of each 3D wall, any normal vector on the face has a same direction with respect to the wall direction.

4. The computer-implemented method of claim anyone of claims 1 to 3, wherein identifying one edge among the edges of the retrieved faces comprises:
- computing a first line passing through the said for each edge of each of the retrieved faces;
- computing, for each of the other edges of the retrieved faces, a second line passing through the other edges of the retrieved faces;
- computing an angle between the first line and the second line;
- if the computed angle is over a predetermined angular tolerance Θ₁° and if the computed angle is not comprised between the range [180° ; 180° - Θ₁°], discarding the edge of the second line, thereby considering that the edges of the first and second lines are not a valid pair of edges, preferably the predetermined angular tolerance Θ₁ has a value comprised between [10° ; 30°], more preferably the predetermined angular tolerance Θ₁° has a value of 25°.

5. The computer-implemented method of claim 4, further comprising:
- obtaining, for the said for each edge of each of the retrieved faces, a first center point, a first start point and a first end point;
- obtaining, for each of the other edges of the retrieved faces, a second center point, a second start point and a second end point;
and wherein:
- computing the first line comprises computing the line passing through the first start point and the first end point; and
- computing the second line comprises computing the line passing through the second start point and the second end point.

6. The computer-implemented method of claim 5, wherein identifying one edge among the edges of the retrieved faces further comprises:
- computing a distance between the first center point and the other edge of the second center point or computing a distance between the second center point and the other edge of the first center point;
- if the computed distance is under a predetermined thickness value T₁ of the 3D wall, discarding the edge of the second center point, thereby considering that the edges of the first and second center point are not a valid pair of edges, preferably the predetermined thickness value T₁ has a value comprised between [1mm ; 5mm], more preferably the predetermined thickness value T₁ has a value of 1mm.

7. The computer-implemented method of claim 5 or 6, wherein identifying one edge among the edges of the retrieved faces further comprises:
- computing a first distance between the first start point and the second start point;
- computing a second distance between the first start point and the second end point;
- computing a third distance between the first end point and the second start point;
- computing a fourth distance between the first end point and the second end point;
- determining the smallest distance among the first, second, third and fourth distances, thereby obtaining a couple of points comprising the two points with which the smallest distance has been computed;
- for each point of the couple of points, computing a vector from the point of the couple to the start point or end point of the edge the point of the couple belongs to, thereby obtain two vectors;
- computing a scalar product between the obtained two vectors; and
- if the computed scalar product is negative, discarding the edge of the said each of the other edges of the retrieved faces.

8. The computer-implemented method of claim 7 combined with claim 2, wherein identifying one edge among the edges of the retrieved faces further comprises:
- computing a segment connecting the first center point and the second center point;
- if no intersection is detected between the computed segment and the domain, discarding the edge of the said each of the other edges of the retrieved faces.

9. The computer-implemented method of claim 7 or 8, further comprising:
- computing a reference minimum distance by summing the determined smallest distance, the first distance, the second distance and a distance between the first center point and the second center point;
- storing, as valid candidate in a list of valid candidates, the edge of the said each of the other edges of the retrieved faces along with its computed reference minimum distance; and
- selecting in the list the valid candidate having the smallest computed reference minimum distance, thereby the valid pair of edges.

10. The computer-implemented method of any one of claims 5 to 9, wherein identifying one edge among the edges of the retrieved faces further comprises:
- computing a distance D₁ between the first line and the second line;
- obtaining a length L₁ of the edge supporting the first line;
- obtaining a length L₂ of the edge supporting the second line;
- if the distance D₁ is larger than the length L₁ and/or the length L₂, discarding the edge of the first line and the edge of the second line, thereby considering that the edges of the first and second lines are not a valid pair of edges.

11. The computer-implemented method of any one of claims 5 to 10, wherein computing the 2D pair wall center line comprises:
- computing a first segment between the first start point and the second start point, a second segment between the first end point and the second end point;
- computing a first middle point of the first segment and a second middle point of the second segment;
- computing a segment connecting the first middle point with the second middle point, thereby obtaining the 2D pair wall center line of the valid pair;
- computing an average wall segment pair thickness from each wall segment pair thickness of each of the 2D pair wall center lines;
- comparing a length of the 2D pair wall center line of each valid pair with the computed average wall segment pair thickness; and
- if the length of one of the 2D pair wall center lines is smaller than the computed average wall segment pair thickness, discarding the 2D pair wall center line.

12. The computer-implemented method of any one of claims 5 to 11, wherein at least one 3D wall comprises at least one nonplanar face, the computing the 2D pair wall center line comprising:
- computing a first segment between the first start point and the second start point, a second segment between the first end point and the second end point;
- computing a first middle point of the first segment and a second middle point of the second segment;
- computing an isoparametric curve connecting the first middle point and the second middle point, thereby obtaining the 2D pair wall center line of the valid pair.

13. The computer-implemented method of any one of claims 5 to 10, wherein computing the 2D pair wall center line of the 3D model further comprises:
- retrieving a lowest vertex among the vertices of the 3D wall in the wall direction;
- computing a plane comprising the lowest vertex and having the wall direction as a normal;
- projecting each 2D pair wall center line on the computed plane, the projection being performed according to the wall direction, thereby obtaining a set of projected 2D pair wall center lines;
- merging the projected 2D pair wall center lines; and
- on the projected 2D pair wall center lines that have been merged, removing vertices are a start point and/or an end point and/or not on a sharp angle, thereby obtaining the 2D wall center line of the 3D model.

14. The computer-implemented method of claim 13, wherein the projecting each 2D pair wall center line on the computed plane further comprises:
- detecting an overlap between at least two projected 2D pair wall center lines;
- if the whole of one projected 2D pair wall center overlaps the other projected 2D pair wall center:
-- selecting one of a closest start point and end point of the at least two projected 2D pair wall center lines that overlap;
-- computing a first cutting line going through the closest start point and normal to the projection plane, and a second cutting line going through the closest end point and normal to the projection plane;
-- cutting the other projected 2D pair wall center using the two cutting lines; and
-- sewing the one projected 2D pair wall center with the other projected 2D pair wall center;
- if part of one projected 2D pair wall center overlaps the other projected 2D pair wall center:
-- selecting one of a closest start point or end point of the at least two projected 2D pair wall center lines that overlap;
-- computing a first cutting line going through the closest start point and normal to the projection plane;
-- cutting the other projected 2D pair wall center using the cutting line; and
-- sewing the one projected 2D pair wall center with the other projected 2D pair wall center.

15. The computer-implemented method of any one of claims 5 to 14 combined with claim 2, wherein for a domain:
- retrieving the 2D wall center lines of the 3D model start points and end points, and their respective tangent directions;
- for each start point:
-- computing a semi-infinite line using the start point as the beginning of the line and having the tangent direction of the start point as its own direction;
-- computing an intersection point of the semi-infinite line with the 2D wall center line of the 3D model;
-- computing a distance between the intersection point and the start point;
-- if the computed distance is smaller than an average thickness, splitting the semi-infinite line, thereby connecting the start point and the intersection point with a segment;
- for each end point:
-- computing a semi-infinite line using the end point as the beginning of the line and having the tangent direction of the start point as its own direction;
-- computing an intersection point of the semi-infinite line with the 2D wall center line of the 3D model;
-- computing a distance between the intersection point and the end point;
-- if the computed distance is smaller than the average thickness, splitting the semi-infinite line, thereby connecting the end point and the intersection point with a segment;
- computing the 2D wall center line of the 3D model by merging the computed 2D pair wall center lines of the valid pairs and the computed segments.

16. A computer program comprising instructions, that when the program is executed by a computer, cause the computer to perform the method of anyone of claims 1 to 15.

17. A computer-readable medium having stored thereon the computer program of claim 16.

18. A system comprising a processing unit communicatively coupled to a memory and a graphical user interface, the memory having recorded thereon the computer program of anyone of claims 1 to 15.
